# EUROPÄISCHE PATENTSCHRIFT

(11) **EP 3 908 094 B1**
(45) Veröffentlichungstag und Bekanntmachung des Hinweises auf die Patenterteilung: **22.02.2023**
(21) Anmeldenummer: 21168942.7
(22) Anmeldetag: 16.04.2021
(51) Int. Cl.: H05K 7/20, F28D 7/00

(54) **VORRICHTUNG ZUR KÜHLUNG ELEKTRISCHER ELEMENTE SOWIE EIN MIT EINER SOLCHEN VORRICHTUNG AUSGESTATTETES ELEKTRISCHES ELEMENT**
DEVICE FOR COOLING ELECTRICAL ELEMENTS AND ELECTRIC ELEMENT EQUIPPED WITH SUCH A DEVICE
DISPOSITIF DE REFROIDISSEMENT DES ÉLÉMENTS ÉLECTRIQUES, AINSI QU'ÉLÉMENT ÉLECTRIQUE ÉQUIPÉ D'UN TEL DISPOSITIF

(30) Priorität: 08.05.2020 DE 102020112554
(43) Veröffentlichungstag der Anmeldung: 10.11.2021
(73) Patentinhaber: TenneT TSO GmbH, 95448 Bayreuth (DE)
(72) Erfinder: LÖBERMANN, Matthias, 31515 Wunstorf (DE)
(74) Vertreter: Scheffler, Jörg

(56) Entgegenhaltungen:
- WO-A1-01/77526
- CN-A- 101 920 228
- CN-A- 102 302 985
- US-A1- 2007 064 390
- US-A1- 2016 374 234

## Beschreibung

Die Erfindung betrifft eine insbesondere für Energieerzeugungs-, Energieübertragungs- oder Energiespeicherungsanlage, beispielsweise Windenergieanlagen bestimmte Vorrichtung zur Kühlung elektrischer Elemente, insbesondere der Leistungselektronik der Anlage, mit einer Kühleinrichtung zur Verlustwärmeabfuhr infolge des Betriebs der elektrischen Elemente, wobei die Kühleinrichtung den zumindest einen dem elektrischen Element der Leistungselektronik zugeordneten Kühlkreislauf sowie einen Wärmetauscher zur Übertragung der Wärme der elektrischen Elemente auf zugeführte Umgebungsluft als Wärmesenke aufweist. Weiterhin betrifft die Erfindung ein elektrisches Element mit einer solchen Vorrichtung.

Bei der Gewinnung von elektrischer Energie kommen immer häufiger Windenergieanlagen zum Einsatz. Es sind sogenannte Offshore-Windparks bekannt, bei denen in einem örtlichen begrenzten Bereich des Meeres mehrere Windräder betrieben werden. Deren erzeugte Energie wird über ein Seekabel an ein gemeinsames Umspannwerk weitergegeben. Dort wird die elektrische Energie in eine erwünschte Hochspannung umgeformt und dann über ein weiteres Seekabel an einen land- oder seegebundenen Netzeinspeisungspunkt eines Energieversorgungsnetzes weitergegeben.

Die elektrischen Komponenten eines Umspannwerks, beispielsweise die Transformatoren, Drosseln und/oder Leistungsschalter, erzeugen während ihres Betriebs Wärme. Diese Wärme muss von den Komponenten abgeführt werden. Diese Verluste werden beispielsweise über Lüfter an die Umgebung abgeführt. Dabei wird mittels der Lüfter kalte Umgebungsluft von außen angesaugt und das entsprechende elektrische Element gekühlt. Die erwärmte Luft wird anschließend wieder nach außen geleitet.

Hierzu sind Kühleinrichtungen bekannt, bei denen mit Hilfe von Lüfteranordnungen die erzeugte Wärme von den Komponenten nach außen an die Umgebungsluft abgegeben wird. Diese Lüfteranordnungen können beispielsweise in die Wände des die elektrischen Elemente einschließenden Gehäuses eingebaut sein.

In der Offshore-Stromübertragung von Windenergieanlagen wird die Übertragungskapazität mittels einer Seestation und einer Landstation bereitgestellt. Die Seestation weist im gegenwärtigen Stand der Technik aufwendige Sekundärsysteme insbesondere zur Bereitstellung von Kühlsystemen auf. Diese Kühlsysteme dienen der Verlustwärmeabfuhr infolge des Betriebs elektrischer Elemente der Leistungselektronik, wie beispielsweise Transformatoren, Umrichter, Gleichrichter, IGBT, Schaltschränke etc.

Auf Offshore-Konverterplattformen wird derzeit zur Kühlung Seewasser mittels Seewasserpumpen über Plattenwärmetauscher für nachgeschaltete Kühlkreisläufe bereitgestellt. Das Kühlwassersystem ist anfällig für marinen Bewuchs oder Befall durch beispielsweise Muscheln. Die Wartung ist deswegen aufwendig. Dabei ist die Seewasserentnahme für die Bereitstellung zur Abfuhr der durch die Leistungselektronik anfallenden Verlustwärme von einer Vielzahl von prozessunterstützenden verfügbarkeitswichtigen Nebensystemen abhängig.

Es ist auch bereits bekannt, die zugeführte Luft zunächst zu filtern und zu entfeuchten, bevor sie von einem Ventilator zu den Generatorteilen zugeführt wird, wodurch im Vergleich zu einem konventionellen Wärmetauscher die Konstruktion einfacher sein soll.

Ein Nachteil derartiger Kühleinrichtungen besteht darin, dass die vorgesehenen Lüfteranordnungen zumindest teilweise dem aggressiven Seeklima, insbesondere dem Salzwasser, ausgesetzt sind. Dies führt dazu, dass ein hoher Aufwand im Hinblick auf den Korrosionsschutz für diese Kühlsysteme betrieben werden muss.

Aus der WO 2001 0 775 26 A1 ist eine Windenergieanlage mit einem Wärmetauschersystem bestehend aus einer im Bereich des Generators angeordneten Wärmeaufnahmeeinheit und einer Wärmeabgabeeinheit bekannt, die durch ein ein flüssiges Kühlmittel führendes Leitungssystem verbunden sind. Die Wärme wird über die Außenwand des Turms an die Außenluft oder über die Außenwandung an das umgebende Meerwasser abgegeben.

Die DE 10 2019 112 376 A1 betrifft einen Wärmetauscherzyklon zum Tauschen von Wärme zwischen einem staubförmigen Gut und einem Gas, aufweisend einen Einlass und einen Auslass für Gas sowie einen Einlass und einen Auslass für das staubförmige Gut. Der Wärmetauscherzyklon weist einen zylindrischen Trennraum auf, an den sich nach unten ein konischer Trennraum anschließt, wobei ein Tauchrohr für das Gas in den gemeinsamen Trennraum ragt. In dem Wärmetauscherzyklon wird die Wärme von dem Gas auf das staubförmige Gut übertragen.

Die CN 2 650 051 Y bezieht sich auf einen Zyklon-Wärmetauscher zur Abwärmerückgewinnung und Entstaubung von hochtemperiertem und staubigem Rauchgas. Dabei wird ein Wärmeträgeröl als Abwärmeträger in dem Zyklon-Wärmetauscher verwendet.

Die US 2007 / 0 064 390 A1 betrifft die Kühlung von elektronischen Vorrichtungen, deren Betriebswärme mittels eines Kühlkörpers abgeführt werden muss. Eine Ansammlung von Staub auf dem Kühlkörper oder der Wärmequelle verringert grundsätzlich den Wärmeaustauscheffekt der Luftströmung. Um zu verhindern, dass sich Staub auf der Wärmequelle oder dem Kühlkörper ansammelt, hat die Vorrichtung einen Zyklon, der als Luftreiniger und -beschleuniger dient, sodass gereinigte Luft auf den Kühlkörper geblasen wird.

Außerdem beschreibt die US 2016 / 0 374 234 A1 eine Vorrichtung zum Kühlen elektronischer Bauteile, wobei ein Kühlkreislauf durch einen Wärmetauscher gekühlt wird.

Eine Windenergieanlage mit einem völlig geschlossenen oder teilweise geschlossenen Kühlkreislauf ist aus WO 99/30031 A1 bekannt.

Ferner bezieht sich die CN 1 02 302 985 A auf einen Zyklon-Wärmeaustauscher bzw. -abscheider, wobei die innere Fläche einen Zyklonabscheider bildet und die äußere Fläche als Wärmeaustauscher dient. Die Luftgeschwindigkeit wird so gesteuert, dass die Anforderungen an die Staubentladung erfüllt werden.

Außerdem offenbart die CN 1 01 920 228 A einen Entstaubungs- und Luftkühlungswärmetauscher, der für eine Biomasse-Wirbelschicht verwendet wird und die Funktionen der Entstaubung und des Luftkühlungswärmetauschs erfüllt. Der Staubsammel- und Luftkühlungswärmetauscher umfasst einen Zyklonstaubsammler, wobei ein Zwischenraum zwischen der Innenwand und der Außenwand des Gasauslassrohrs als eine Wärmetauschkammer ausgeführt ist, sodass die Staubabscheidung und Luftkühlung gleichzeitig realisiert werden.

Der Erfindung liegt die Aufgabe zugrunde, eine Möglichkeit zu schaffen, eine ohne zusätzliche elektrische Energiezufuhr betreibbare Vorrichtung zur Kühlung der elektrischen Elemente der Windenergieanlage zu schaffen. Insbesondere soll eine gegenüber Korrosion oder marinen Bewuchs kaum anfällige Vorrichtung geschaffen werden.

Diese Aufgabe wird erfindungsgemäß mit einer Vorrichtung gemäß den Merkmalen des Anspruchs 1 gelöst. Die weitere Ausgestaltung der Erfindung ist den Unteransprüchen zu entnehmen.

Erfindungsgemäß weist also eine Vorrichtung einen als Zyklon ausgeführten, von zugeführter Umgebungsluft durchströmbaren Wärmetauscher mit einer zumindest abschnittsweise zu einer Mittellängsachse rotationssymmetrischen Wärmetauscherkammer zur Übertragung der Wärme auf die Umgebungsluft auf, wobei der Wärmetauscher eine an der Wärmetauscherkammer tangential bezogen auf die rotationssymmetrische Wärmetauscherkammer angeordnete Einlassöffnung mit insbesondere horizontaler Zuführleitung für die zugeführte Umgebungsluft sowie eine in dem Wärmetauscher im Wesentlichen koaxial zu der Mittellängsachse des Wärmetauschers angeordnete, als insbesondere hohlzylindrisches Tauchrohr ausgeführte Auslassleitung mit einer Eintrittsöffnung und mit einer Auslassöffnung aufweist, sodass zwischen einer rotationssymmetrischen Wandfläche der Wärmetauscherkammer und der Auslassleitung eine kreisringförmige Fläche begrenzt ist, wobei die Einlassöffnung geodätisch oberhalb der Eintrittsöffnung der Auslassleitung mit einem vertikalen Abstand angeordnet ist, sodass sich ein kreisringförmiger Strömungskanal zwischen einer Wandfläche der Wärmetauscherkammer und der Auslassleitung erstreckt, und wobei der Wärmetauscher zumindest ein von der zugeführten Luft anströmbares, thermisch mit dem Kühlkreislauf gekoppeltes Kühlelement mit einer in dem Strömungskanal angeordneten Kühlfläche aufweist. Erfindungsgemäß wird es hierdurch erstmals möglich, bei einer insbesondere für Offshore-Windenergieanlagen bestimmten Vorrichtung weitgehend auf aktive Kühlsysteme, insbesondere Pumpen, Ventilatoren, Antriebe für den Medientransport, Kompressoren und dergleichen zu verzichten und demgegenüber ein vollständig passives System zu schaffen, welches insbesondere ohne bewegliche, vor allem rotierende Funktionselemente auskommt.

Im Gegensatz zu den bestehenden Vorurteilen in der Fachwelt, wonach eine konvektive Kühlung für die elektrischen Elemente der Leistungselektronik der Windenergieanlage nicht wirtschaftlich sein kann, da eine erhebliche Installationsmasse für Luftwärmetauscher wegen der geringen Enthalpie der Seeluft sowie wartungsintensive Lüfter verbaut werden müssen, hat es sich gezeigt, dass durch das erfindungsgemäße Zweikreiskühlsystem in Verbindung mit einer Rückkühlung in einem Zyklon nicht nur die erforderliche Kühlleistung ohne angetriebene Systeme erbracht werden kann, sondern zudem auch die Probleme verursacht durch marinen Bewuchs oder Befall durch beispielsweise Muscheln ebenso wie Korrosion durch Meerwasser oder salzhaltige Umgebungsluft und der damit verbundene hohe Aufwand im Hinblick auf entsprechende Schutzmaßnahmen weitgehend vermieden werden können.

Mehr noch kann auf eine regelmäßige Wartung verzichtet werden. Es hat sich sogar gezeigt, dass nahezu alle wesentlichen Elemente der Erfindung, insbesondere Kühlelement, Kühlfläche, Wärmetauscher sowie Ein- und Auslassleitungen aus Kunststoff hergestellt werden können.

Der wesentliche erfindungsgemäße Gedanke geht von der Erkenntnis aus, dass eine bloße Anströmung einer Wärmetauscherfläche durch Umgebungsluft für die erforderliche Wärmeabfuhr unzureichend ist. Demgegenüber führt die Gestaltung der Wärmetauscherkammer als Zyklon zu einem Spiralwirbel, also einem Luftwirbel mit annähernd senkrechter Drehachse, welcher innerhalb eines vergleichsweise geringen Kammervolumens eine große Kühlfläche überströmt und dadurch bereits zu einem wesentlich erhöhten Wärmeübergangskoeffizienten und einer entsprechenden Effizienzsteigerung führt. Dabei folgt die Luftströmung dem Strömungskanal in einem abwärts gerichteten Spiralwirbel, an dessen unteren Ende sich die Auslassöffnung der zu der Wandfläche der Wärmetauscherkammer bzw. der Wirbelachse konzentrisch angeordneten Auslassleitung befindet.

Die nun erwärmte Luft steigt in der Auslassleitung auf und erfährt aufgrund des Kamineffekts eine Beschleunigung. Infolgedessen entsteht ein relativer Unterdruck innerhalb der Wärmetauscherkammer im Bereich der Auslassöffnung, sodass durch die Druckdifferenz gegenüber der Einlassöffnung eine Saugströmung entsteht. Der Volumenstrom der in die Wärmetauscherkammer eintretenden Umgebungsluft geht dadurch weit über eine bloße Windanströmung hinaus und erreicht ein Vielfaches der umgebenden freien Luftströmung. Erfindungsgemäß lässt sich so eine wesentliche Verstärkung der Wärmeabfuhr durch eine effiziente Nutzung der Umgebungsluftströmung erreichen.

Hinzu kommt noch ein weiterer vorteilhafter Effekt infolge des Unterdrucks, indem dieser das Verdampfen der mit der Umgebungsluft mitgeführten flüssigen Bestandteile beschleunigt und somit die Kühlwirkung weiter verbessert. Der Vorteil des Unterdrucks besteht somit vor allem in der niedrigeren Verdampfungstemperatur, durch die der Energieeinsatz insgesamt minimiert werden kann.

Eine besonders vorteilhafte Ausführungsform der Erfindung wird dadurch erreicht, dass in dem Kühlkreislauf der als Zyklon ausgeführte Wärmetauscher geodätisch oberhalb des elektrischen Elements angeordnet ist. Hierdurch steigt das durch die Abwärme der elektrischen Elemente erwärmte Kühlmittel des primären Kühlkreislaufs in einer Kühlmittelleitung zu dem Zyklon auf. Das in dem Zyklon rückgekühlte Kühlmittel sinkt ab und gelangt so durch eine weitere Kühlmittelleitung zurück zu dem unterhalb liegenden elektrischen Element.

Weiterhin ist es besonders zweckmäßig, wenn sich das zumindest eine Kühlelement im Wesentlichen radial in den Strömungskanal zwischen einer Wandfläche der WT-Kammer bis zu dem Tauchrohr erstreckt oder aber das Kühlelement als Trennfläche den Strömungskanal ober- bzw. unterseitig begrenzt. Hierdurch wird ein wesentlich optimierter Wärmeübergang erreicht.

Indem gemäß einer weiteren, ebenfalls besonders Erfolg versprechenden Abwandlung der Erfindung die Kühlflächen als Strömungsleitelemente ausgeführt sind und eine Ablenkung der zugeführten Luft in vertikaler Richtung nach unten begünstigen bzw. erzwingen und hierzu vorzugsweise einen Anstellwinkel bzw. Neigungswinkel bezogen auf eine Querschnittsebene der Auslassleitung aufweisen, wird eine effiziente Strömungsablenkung erreicht, wobei zugleich unerwünschte Strömungsverluste wesentlich reduziert werden. Die Kühlflächen können dabei beispielsweise ähnlich einem Schraubengewinde mit einer konstanten oder veränderlichen Steigung ausgeführt oder wie Turbinenschaufeln geformt sein.

Als Kühlmittel des Kühlkreislaufs kann ein gasförmiges Fluid eingesetzt werden. Vorzugsweise wird hingegen ein flüssiges Kühlmittel, insbesondere Reinstwasser, verwendet. Weiterhin können auch Kühlmittel auf der Basis von Alkohol oder Ester verwendet werden, um so beispielsweise einen Schutz vor Einfrieren zu erreichen und die Betriebssicherheit auch bei sehr niedrigen Umgebungstemperaturen sicherzustellen.

Weiterhin können die in den Strömungskanal hineinreichenden und von der Umgebungsluft anströmbaren Kühlelemente von dem Kühlmittel zumindest abschnittsweise von dem insbesondere flüssigen Kühlmittel des Kühlkreislaufs durchströmbar ausgeführt sein. Alternativ können die in den Strömungskanal hineinreichenden Kühlflächen jedoch auch lediglich thermisch gekoppelt, insbesondere also thermisch leitfähig mit dem von dem Kühlmittel durchströmten Bereich des Kühlelements verbunden sein.

Eine andere, ebenfalls besonders vorteilhafte Ausführungsform der Erfindung wird auch dadurch erreicht, dass dem Kühlkreislauf ein insbesondere elektrisch betriebenes Heizelement zugeordnet ist, um so das Kühlmittel in dem Leitungsabschnitt der Kühlmittelleitung zwischen dem elektrischen Element und dem Wärmetauscher bedarfsweise erwärmen zu können. Hierdurch wird die Strömung des flüssigen Kühlmittels beschleunigt oder beispielsweise bei geringer Abwärme aktiviert. Sobald das Kühlmittel zirkuliert, ist eine externe Zufuhr thermischer Energie nicht mehr erforderlich.

Eine andere, ebenfalls besonders sinnvolle Ausgestaltungsform der Erfindung wird auch dadurch erreicht, dass der als Zyklon ausgeführte Wärmetauscher zumindest eine Zuführöffnung für in die Wärmetauscherkammer zuführbare Flüssigkeit aufweist. Die Bereitstellung von Kondensat als entsalztes Kühlwasser verbessert die Enthalpie und damit die thermische Transportkapazität für eine konvektive Nasskühlung. Dadurch lässt sich auch der Querschnitt des Strömungskanals verkleinern, indem mit der Bereitstellung von Kühlwasser eine Verbesserung der Wärmeübertragung zwischen den Medien und Phasen der konvektiven Nasskühlung erreicht wird. Durch die Nass-Konvektion ändert sich das Enthalpie-Potential erheblich und kann je nach Temperaturspreizung zwischen Kühlobjekt und Umgebungsluft um den Faktor 8 bis 10 erhöht werden.

Eine andere, ebenfalls besonders Erfolg versprechende Ausgestaltungsform der Erfindung wird dadurch erreicht, dass die Vorrichtung ein zumindest ein elektrisches Element einschließendes, druckdichtes Gehäuse mit einer Gehäusewandfläche aufweist, durch die zumindest eine Kühlmittelleitung des Kühlkreislaufs mit einem dem jeweiligen elektrischen Element zugeordneten Wärmetauscher verbunden ist, der beispielsweise als ein Kühlmantel ausgeführt sein kann und das zu kühlende elektrische Element, beispielsweise ein Konvertermodul, an dessen Außenfläche einschließen kann. Selbstverständlich kann das elektrische Element zur Kühlung auch durchströmbar ausgeführt sein. Der Wärmetauscher kann auch zur Kühlung des in dem Gehäuse enthaltenen gasförmigen Fluids, beispielsweise Inertgas, ausgeführt sein und hierzu bevorzugt in einem oberen, deckennahen Bereich innerhalb des Gehäuses angeordnet sein, um so das von der Steuerungs- und Regelelektronik des elektrischen Elements erwärmte Gas effizient kühlen zu können. Das in dem Gehäuse enthaltene Gas wird dadurch zu einem Primärkühlmedium. Eine Modifikation von marktüblichen elektrischen Bestandskomponenten ist damit nicht mehr erforderlich. Sämtliche elektrischen Elemente einer (Offshore-)Konverteranlage können damit in die Vorrichtung integriert werden.

Besonders bevorzugt ist das Gehäuse im Betrieb mit einem Inertgas mit Überdruck gegenüber dem Umgebungsdruck gefüllt. Indem die elektrischen Elemente in einem druckdichten Gehäuse angeordnet sind, welches mit Inertgas mit Überdruck gefüllt ist, wird bereits eine wesentlich verbesserte elektrische Durchschlagfestigkeit erreicht.

Weiterhin wird die erfindungsgemäße Aufgabe noch mit einem elektrischen Element gelöst, das mit einer solchen Vorrichtung zur Kühlung ausgestattet ist.

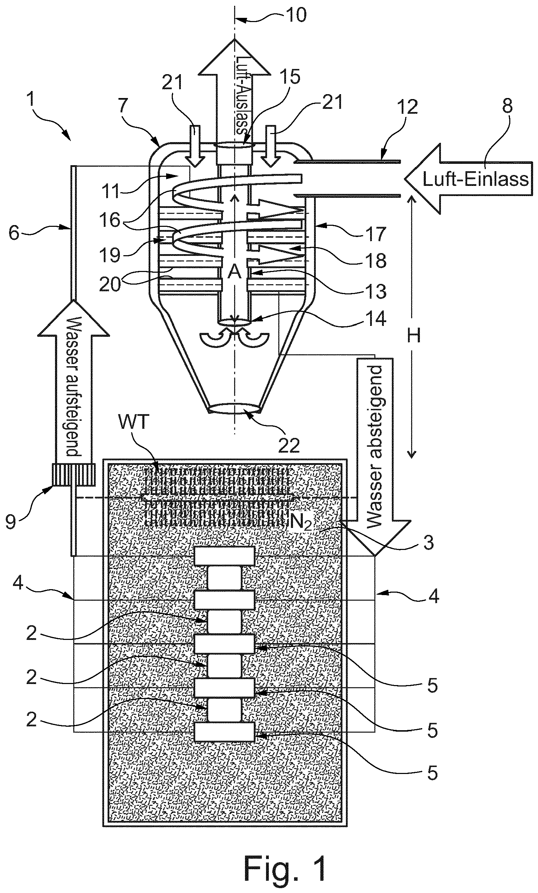

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt in einer Prinzipdarstellung eine für eine Offshore-Windenergieanlage bestimmte Vorrichtung 1 zur Abfuhr der Abwärme elektrischer Elemente 2 der Leistungselektronik, beispielsweise Konvertermodule. Die elektrischen Elemente 2 sind in einem druckdicht verschließbaren Gehäuse 3 angeordnet, welches mit einem Inertgas, beispielsweise N2, mit Überdruck gefüllt ist, um eine gesteigerte elektrische Durchschlagfestigkeit zu erreichen. Um zugleich eine effiziente Wärmeabfuhr zu ermöglichen, hat die Vorrichtung 1 einen Kühlkreislauf mit einer Kühlmittelleitung 4 für Reinstwasser als Kühlmittel, welche durch das Gehäuse 3 mit einem Kühlmantel 5 der elektrischen Elemente 2 im Inneren verbunden ist, sodass die Abwärme auf das Kühlmittel übertragen wird. Lediglich andeutungsweise ist ein ergänzend oder alternativ einsetzbarer, von dem Kühlmittel durchströmbarer Wärmetauscher WT in einem oberen Bereich des Gehäuses 3 dargestellt, um so das Inertgas und damit durch Konvektion auch die elektrischen Elemente 2 zu kühlen.

Das so erwärmte Kühlmittel steigt in einem Steigrohr 6 der Kühlmittelleitung 4 zu einem geodätisch oberhalb des Gehäuses 3 mit einem Abstand H angeordneten, als Zyklon ausgeführten Wärmetauscher 7 auf. In dem Wärmetauscher 7 wird mittels zugeführter Umgebungsluft 8 eine Rückkühlung des Kühlmittels des Kühlkreislaufs erreicht, welches dadurch absinkt und in das Gehäuse 3 zurückgeführt wird. Der Kühlmittelstrom in dem Kühlkreislauf ist grundsätzlich selbsterhaltend ausgelegt, dennoch kann durch kurzfristige Zuheizung mittels eines Heizelements 9 der Kühlmittelstrom beschleunigt oder aktiviert werden.

Der als Zyklon ausgeführte Wärmetauscher 7 der Vorrichtung 1 hat eine zu einer Mittellängsachse 10 rotationssymmetrische Wärmetauscherkammer 11, die von der Umgebungsluft 8 durchströmbar ist. Hierzu hat die Wärmetauscherkammer 11 eine tangential angeordnete Einlassöffnung 12, durch welche die Umgebungsluft 8 als im Wesentlichen horizontale Luftströmung eintritt. Innerhalb der Wärmetauscherkammer 11 ist eine als Tauchrohr ausgeführte Auslassleitung 13 zu der Mittellängsachse 10 koaxial angeordnet, die eine Eintrittsöffnung 14 für die erwärmte Umgebungsluft 8 und eine Auslassöffnung 15 aufweist, durch welche die erwärmte Luft in die Umgebung entweichen kann. Die Einlassöffnung 12 für die Umgebungsluft 8 ist vertikal mit einem Abstand A oberhalb der Eintrittsöffnung 14 der Auslassleitung 13 angeordnet, sodass die zugeführte Umgebungsluft 8 in eine Abwärtsbewegung gezwungen wird, die infolge der tangentialen Zuführung einer spiralförmigen Luftströmung 16 um die zentrale Auslassleitung 13 herum in einem durch eine Wandfläche 17 der Wärmetauscherkammer 11 und die Auslassleitung 13 begrenzten ringförmigen Strömungskanal 18 folgt. In dem Strömungskanal 18 sind mehrere Kühlelemente 19 mit radialen Kühlflächen 20 angeordnet, die mit dem Kühlkreislauf thermisch gekoppelt, aber stofflich getrennt sind. Die Kühlflächen 20 können wie andeutungsweise dargestellt ihrerseits durchströmbar sein oder lediglich aus einem gut wärmeleitenden Material bestehen.

Nachdem die Umgebungsluft 8 durch die Einlassöffnung 12 tangential in die Wärmetauscherkammer 11 eingetreten ist, wird diese durch eine düsenartige Zuführöffnung 21 zur Einbringung einer Nassphase mit Kühlwasser, insbesondere Kondensat, angereichert. Die Luftströmung 16 rotiert so mit der Feuchtigkeit angereichert in Schraubenbahnen nach unten, bis das untere Ende der als Tauchrohr ausgeführten Auslassleitung 13 erreicht ist, um dann durch die Auslassleitung 13 aus der Auslassöffnung 15 in die Umgebung auszuströmen. Während die mit Wasserdampf angereicherte Umgebungsluft 8 in dem Strömungskanal 18 rotiert, überströmt sie die Wärme transportierenden Kühlflächen 20 der Kühlelemente 19 und entzieht ihnen Wärmeenergie. Die wärmetransportierenden Kühlelemente 19 sind beispielsweise von Massivmetallheatpipes oder Kühlmittel durchströmte Rohre. Idealerweise werden sie mit einem strömungsgünstigen Tropfenquerschnitt ausgebildet. Wasseranteile, die während des Vorgangs nicht in die Dampfphase überführt werden, scheiden sich ab und werden über eine Öffnung 22 im Bodenbereich der Wärmetauscherkammer 11 abgeleitet und gegebenenfalls einer Kühlwasserrückgewinnung zugeführt.

Dadurch kann der Kühlungsprozess für einen Offshore-Konverter erheblich hinsichtlich Investitions- und Instandhaltungsaufwand aufgrund geringerer konstruktiver Abstände, geringer statischer Masse und betrieblicher Handhabung verbessert werden.

Es ist von Vorteil für das Naturumlaufverfahren, im Kühlkreislauf Reinstwasser zur Abfuhr der Spitzenwärmeleistung an den Konvertermodulen der elektrischen Elemente 2 zu verwenden.

Ferner ergibt sich die Möglichkeit, das Kondensatsammelbecken im Naturumlaufkeislauf mit einem Wämetauscher gegen Einfrieren vorzuheizen und die Zuführöffnung 21 der Nassphaseneinspritzung ebenfalls vorzuheizen. Durch die Aktivierung des Kondensatsammelbehälters als thermische Senke für die Kühlung der Konvertermodule ergibt sich ein Dämpfungseffekt für die Aufheiz- und Abkühlphase, die Lastschwankungen effektiv dämpft und damit die Lebensdauer der elektrischen Elemente 2 erhöht.

**BEZUGSZEICHENLISTE**

| | | | |
|---|---|---|---|
| 1 | Vorrichtung | 16 | Luftströmung |
| 2 | Element | 17 | Wandfläche |
| 3 | Gehäuse | 18 | Strömungskanal |
| 4 | Kühlmittelleitung | 19 | Kühlelement |
| 5 | Kühlmantel | 20 | Kühlfläche |
| 6 | Steigrohr | 21 | Zuführöffnung |
| 7 | Wärmetauscher | 22 | Öffnung |
| 8 | Umgebungsluft | | |
| 9 | Heizelement | A | Abstand |
| 10 | Mittellängsachse | H | Abstand |
| | | WT | Wärmetauscher |
| 11 | Wärmetauscherkammer | | |
| 12 | Einlassöffnung | | |
| 13 | Auslassleitung | | |
| 14 | Eintrittsöffnung | | |
| 15 | Auslassöffnung | | |

## Patentansprüche

1. Vorrichtung (1) zur Kühlung elektrischer Elemente (2), insbesondere der Leistungselektronik einer Energieerzeugungs-, Energieübertragungs- und/oder Energiespeicherungsanlage mit einer Kühleinrichtung, die zumindest einen dem elektrischen Element (2) zugeordneten Kühlkreislauf sowie einen von zugeführter Umgebungsluft durchströmbaren Wärmetauscher (7) zur Übertragung der Wärme der elektrischen Elemente (2) auf die zugeführte Umgebungsluft (8) aufweist, **dadurch gekennzeichnet, dass** der Wärmetauscher (7) als Zyklon mit einer zumindest abschnittsweise zu einer Mittellängsachse (10) rotationssymmetrischen Wärmetauscherkammer (11) zur Übertragung der Wärme auf die Umgebungsluft (8) ausgeführt ist und eine an der Wärmetauscherkammer (11) tangential angeordnete Einlassöffnung (12) für die zugeführte Umgebungsluft (8) sowie eine in dem Wärmetauscher (7) im Wesentlichen koaxial zu der Mittellängsachse (10) angeordnete Auslassleitung (13) mit einer Eintrittsöffnung (14) und mit einer Auslassöffnung (15) aufweist, wobei die Einlassöffnung (12) und die Eintrittsöffnung (14) der Auslassleitung (13) einen vertikalen Abstand (A) aufweisen, sodass sich ein Strömungskanal (18) zwischen einer Wandfläche (17) der Wärmetauscherkammer (11) und der Auslassleitung (13) erstreckt, und wobei der Wärmetauscher (7) zumindest ein von der zugeführten Umgebungsluft (8) anströmbares, thermisch mit dem Kühlkreislauf gekoppeltes Kühlelement (19) der Kühleinrichtung mit einer in dem Strömungskanal (18) angeordneten Kühlfläche (20) aufweist.

2. Vorrichtung (1) nach Anspruch 1, **dadurch gekennzeichnet, dass** die Auslassleitung (13) eine Eintrittsöffnung (14) aufweist, die mit einem geodätischen Abstand unterhalb der Auslassöffnung (15) der Auslassleitung (13) angeordnet ist.

3. Vorrichtung (1) nach Anspruch 1 oder 2, **dadurch gekennzeichnet, dass** der Strömungskanal (18) schraubenlinienförmig oder helixförmig in mehreren Windungen um die Auslassleitung (13) zu der Eintrittsöffnung (14) der Auslassleitung (13) geführt ist.

4. Vorrichtung (1) nach zumindest einem der vorhergehenden Ansprüche, **dadurch gekennzeichnet, dass** der Wärmetauscher (7) geodätisch mit einem Abstand (H) oberhalb des elektrischen Elements (2) angeordnet ist.

5. Vorrichtung (1) nach zumindest einem der vorhergehenden Ansprüche, **dadurch gekennzeichnet, dass** das zumindest eine Kühlelement (19) im Wesentlichen radial in dem Strömungskanal (18) angeordnet ist.

6. Vorrichtung (1) nach zumindest einem der vorhergehenden Ansprüche, **dadurch gekennzeichnet, dass** die Kühlflächen (20) als Strömungsleitelemente ausgeführt sind und eine Ablenkung der zugeführten Umgebungsluft (8) in vertikaler Richtung bewirken.

7. Vorrichtung (1) nach zumindest einem der vorhergehenden Ansprüche, **dadurch gekennzeichnet, dass** dem Kühlkreislauf ein insbesondere elektrisch betriebenes Heizelement (9) zugeordnet ist.

8. Vorrichtung (1) nach zumindest einem der vorhergehenden Ansprüche, **dadurch gekennzeichnet, dass** der Wärmetauscher (7) zumindest eine Zuführöffnung (21) für Flüssigkeit aufweist.

9. Vorrichtung (1) nach zumindest einem der vorhergehenden Ansprüche, **dadurch gekennzeichnet, dass** die Vorrichtung (1) ein zumindest ein elektrisches Element (2) einschließendes druckdichtes Gehäuse (3) mit einer Gehäusewandfläche aufweist, durch die zumindest eine Kühlmittelleitung (4) des Kühlkreislaufs mit einem Wärmetauscher (7) verbunden ist.

10. Elektrisches Element (2) mit einer Vorrichtung (1) nach zumindest einem der vorhergehenden Ansprüche.

## Claims

1. Apparatus (1) for cooling of electrical elements (2), in particular of the power electronics of an energy-generating, energy-transmitting and/or energy-storage installation, having a cooling device which has at least one cooling circuit assigned to the electrical element (2) and has a heat exchanger (7) through which fed ambient air is able to flow and which serves for transfer of the heat of the electrical elements (2) to the fed ambient air (8), **characterized in that** the heat exchanger (7) is designed as a cyclone heat exchanger with a heat-exchanger chamber (11), which heat-exchanger chamber is at least sectionally rotationally symmetrical in relation to a central longitudinal axis (10) and serves for transfer of the heat to the ambient air (8), and has an inlet opening (12), arranged in a manner tangential to the heat-exchanger chamber (11), for the fed ambient air (8) and has an outlet line (13) which is arranged in the heat exchanger (7) substantially coaxially in relation to the central longitudinal axis (10) and which has an entry opening (14) and an outlet opening (15), wherein the inlet opening (12) and the entry opening (14) of the outlet line (13) are spaced apart vertically by a distance (A), so that a flow channel (18) extends between a wall surface (17) of the heat-exchanger chamber (11) and the outlet line (13), and wherein the heat exchanger (7) has at least one cooling element (19) of the cooling device, which cooling element is able to be flowed against by the fed ambient air (8) and is thermally coupled to the cooling circuit and has a cooling surface (20) arranged in the flow channel (18).

2. Apparatus (1) according to Claim 1, **characterized in that** the outlet line (13) has an entry opening (14) which is arranged at a geodetic distance below the outlet opening (15) of the outlet line (13).

3. Apparatus (1) according to Claim 1 or 2, **characterized in that** the flow channel (18) is led in the manner of a screw or helically with multiple windings around the outlet line (13) to the entry opening (14) of the outlet line (13).

4. Apparatus (1) according to at least one of the preceding claims, **characterized in that** the heat exchanger (7) is arranged geodetically at a distance (H) above the electrical element (2).

5. Apparatus (1) according to at least one of the preceding claims, **characterized in that** the at least one cooling element (19) is arranged in a substantially radial manner in the flow channel (18).

6. Apparatus (1) according to at least one of the preceding claims, **characterized in that** the cooling surfaces (20) are designed as flow-guiding elements and bring about a diversion of the fed ambient air (8) into the vertical direction.

7. Apparatus (1) according to at least one of the preceding claims, **characterized in that** an in particular electrically operated heating element (9) is assigned to the cooling circuit.

8. Apparatus (1) according to at least one of the preceding claims, **characterized in that** the heat exchanger (7) has at least one feed opening (21) for liquid.

9. Apparatus (1) according to at least one of the preceding claims, **characterized in that** the apparatus (1) has a pressure-tight housing (3) which encloses at least one electrical element (2) and which has a housing wall surface by way of which at least one coolant line (4) of the cooling circuit is connected to a heat exchanger (7).

10. Electrical element (2) having an apparatus (1) according to at least one of the preceding claims.

## Revendications

1. Dispositif (1) pour le refroidissement d'éléments électriques (2), notamment de l'électronique de puissance d'une installation de production d'énergie, de transfert d'énergie et/ou d'accumulation d'énergie avec un appareil de refroidissement, qui présente au moins un circuit de refroidissement associé à l'élément électrique (2) ainsi qu'un échangeur de chaleur (7) pouvant être traversé par de l'air ambiant amené pour le transfert de la chaleur des éléments électriques (2) à l'air ambiant amené (8), **caractérisé en ce que** l'échangeur de chaleur (7) est réalisé sous forme de cyclone avec une chambre d'échangeur de chaleur (11) à symétrie de rotation au moins par sections par rapport à un axe longitudinal médian (10) pour le transfert de la chaleur à l'air ambiant (8) et présente une ouverture d'entrée (12) agencée tangentiellement sur la chambre d'échangeur de chaleur (11) pour l'air ambiant amené (8), ainsi qu'une conduite de sortie (13) avec une ouverture d'admission (14) et avec une ouverture de sortie (15), agencée dans l'échangeur de chaleur (7) essentiellement coaxialement à l'axe longitudinal médian (10), l'ouverture d'entrée (12) et l'ouverture d'admission (14) de la conduite de sortie (13) présentant une distance verticale (A) de telle sorte qu'un canal d'écoulement (18) s'étend entre une surface de paroi (17) de la chambre d'échangeur de chaleur (11) et la conduite de sortie (13), et l'échangeur de chaleur (7) présentant au moins un élément de refroidissement (19) de l'appareil de refroidissement pouvant être alimenté par l'air ambiant amené (8), couplé thermiquement au circuit de refroidissement, avec une surface de refroidissement (20) agencée dans le canal d'écoulement (18).

2. Dispositif (1) selon la revendication 1, **caractérisé en ce que** la conduite de sortie (13) présente une ouverture d'admission (14), qui est agencée à une distance géodésique en dessous de l'ouverture de sortie (15) de la conduite de sortie (13) .

3. Dispositif (1) selon la revendication 1 ou 2, **caractérisé en ce que** le canal d'écoulement (18) est guidé sous forme hélicoïdale ou sous forme d'hélice en plusieurs spires autour de la conduite de sortie (13) vers l'ouverture d'admission (14) de la conduite de sortie (13).

4. Dispositif (1) selon au moins l'une quelconque des revendications précédentes, **caractérisé en ce que** l'échangeur de chaleur (7) est agencé géodésiquement à une distance (H) au-dessus de l'élément électrique (2).

5. Dispositif (1) selon au moins l'une quelconque des revendications précédentes, **caractérisé en ce que** l'au moins un élément de refroidissement (19) est agencé essentiellement radialement dans le canal d'écoulement (18) .

6. Dispositif (1) selon au moins l'une quelconque des revendications précédentes, **caractérisé en ce que** les surfaces de refroidissement (20) sont réalisées sous forme d'éléments de guidage d'écoulement et provoquent une déviation de l'air ambiant amené (8) dans la direction verticale.

7. Dispositif (1) selon au moins l'une quelconque des revendications précédentes, **caractérisé en ce qu'un** élément chauffant (9), notamment à fonctionnement électrique, est associé au circuit de refroidissement.

8. Dispositif (1) selon au moins l'une quelconque des revendications précédentes, **caractérisé en ce que** l'échangeur de chaleur (7) présente au moins une ouverture d'amenée (21) pour du liquide.

9. Dispositif (1) selon au moins l'une quelconque des revendications précédentes, **caractérisé en ce que** le dispositif (1) présente un boîtier (3) étanche à la pression contenant au moins un élément électrique (2), ayant une surface de paroi de boîtier à travers laquelle au moins une conduite de réfrigérant (4) du circuit de refroidissement est reliée à un échangeur de chaleur (7).

10. Élément électrique (2) comprenant un dispositif (1) selon au moins l'une quelconque des revendications précédentes.
